# FASCICULE DE BREVET EUROPEEN

(11) **EP 2 645 371 B1**
(45) Date de publication et mention de la délivrance du brevet: **27.02.2019**
(21) Numéro de dépôt: 13160576.8
(22) Date de dépôt: 22.03.2013
(51) Int. Cl.: G11C 16/04, H01L 21/28, H01L 29/423, H01L 29/66, H01L 29/788, H01L 27/11568

(54) **CELLULE MÉMOIRE ÉLECTRONIQUE À DOUBLE GRILLE ET PROCÉDÉ DE FABRICATION D'UNE TELLE CELLULE**
ELEKTRONISCHE SPEICHERZELLE MIT DOPPEL-GATE, UND HERSTELLUNGSVERFAHREN EINER SOLCHEN SPEICHERZELLE
DOUBLE-GATE ELECTRONIC MEMORY CELL AND METHOD FOR MANUFACTURING SAME

(30) Priorité: 29.03.2012 FR 1252842
(43) Date de publication de la demande: 02.10.2013
(73) Titulaire: COMMISSARIAT À L'ÉNERGIE ATOMIQUE ET AUX ÉNERGIES ALTERNATIVES, 75015 Paris (FR)
(72) Inventeur: Charpin-Nicolle, Christelle, 38120 Fontanil-Cornillon (FR)
(74) Mandataire: Lebkiri, Alexandre

(56) Documents cités:
- US-A1- 2006 028 868
- US-A1- 2009 103 355
- MASOERO L ET AL: "Scalability of split-gate charge trap memories down to 20nm for low-power embedded memories", ELECTRON DEVICES MEETING (IEDM), 2011 IEEE INTERNATIONAL, IEEE, 5 décembre 2011 (2011-12-05), pages 9.5.1-9.5.4, XP032095914, DOI: 10.1109/IEDM.2011.6131522 ISBN: 978-1-4577-0506-9

## Description

La présente invention concerne le domaine des cellules mémoires électroniques non volatiles à double grille, et plus particulièrement celui des mémoires Flash à double grille (grille flottante de mémorisation et grille de sélection) trouvant une application particulièrement intéressante dans le domaine de l'électronique embarquée.

Il existe plusieurs types de mémoires non-volatiles, c'est-à-dire des mémoires conservant une information mémorisée en l'absence d'alimentation électrique, pouvant être écrites et/ou effacées électriquement :
- les EPROMs (« Erasable Programmable Read Only Memories » en anglais, ou mémoires mortes effaçables et programmables), dont le contenu peut être écrit électriquement, mais qui doivent être soumises à un rayonnement UV pour effacer les informations mémorisées ;
- les EEPROMs (« Electrically Erasable Programmable ROMs » en anglais, ou mémoires mortes effaçables et programmables électriquement), dont le contenu peut être écrit et effacé électriquement, mais qui requièrent, pour leur réalisation, des surfaces de semi-conducteur plus importantes que les mémoires de type EPROM, et qui sont donc plus coûteuses à réaliser.

Il existe également des mémoires non volatiles, appelées mémoires Flash, qui ne présentent pas les inconvénients des mémoires EPROMs ou EEPROMs mentionnés ci-dessus. En effet, une mémoire Flash est formée d'une pluralité de cellules mémoires pouvant être programmées électriquement de manière individuelle, un grand nombre de cellules, appelé bloc, secteur ou page, pouvant être effacées simultanément et électriquement. Les mémoires Flash combinent à la fois l'avantage des mémoires EPROMs en termes de densité d'intégration et l'avantage des mémoires EEPROMs en termes d'effacement électrique.

De plus, la durabilité et la faible consommation électrique des mémoires Flash les rendent intéressantes pour de nombreuses applications : appareils photos numériques, téléphones cellulaires, imprimantes, assistants personnels, ordinateurs portables, ou encore dispositifs portables de lecture et d'enregistrement sonore, clés USB, etc. De plus, les mémoires Flash ne possèdent pas d'éléments mécaniques, ce qui leurs confère une assez grande résistance aux chocs.

La plupart des mémoires Flash sont du type « stand-alone » et présentent de grandes capacités de stockage, généralement supérieures à 1 Gb, et sont dédiées aux applications de stockage de masse.

Cependant, il existe également des mémoires Flash dites embarquées (« embedded memories ») dont la réalisation est intégrée dans un procédé de type CMOS et qui trouvent un intérêt croissant, par exemple dans les domaines de l'automobile ou des microcontrôleurs, pour le stockage de données ou de codes. Ces mémoires Flash embarquées sont réalisées sur une puce qui comporte également des dispositifs CMOS destinés à réaliser des fonctions logiques autres qu'une mémorisation de données. Ces mémoires Flash embarquées sont généralement réalisées pour des capacités de stockage plus faibles que celles des mémoires de type « stand-alone », leurs capacités pouvant varier généralement de quelques bits à quelques Mb. Les caractéristiques visées des mémoires Flash embarquées sont un faible coût de réalisation, une excellente fiabilité (notamment à haute température), une faible consommation électrique, ou encore une vitesse de programmation élevée, ces caractéristiques étant fonction de l'application à laquelle elles sont destinées.

La plupart des mémoires Flash comportent une structure de type transistor MOS (grille, source, drain et canal) comportant un site de stockage de charges électriques, appelé grille flottante, formé par exemple d'une couche de polysilicium disposée entre deux couches d'oxyde, et disposé entre le matériau électriquement conducteur de grille et le canal du transistor. Une mémorisation est réalisée en appliquant sur le matériau conducteur une tension supérieure à la tension de seuil, par exemple comprise entre 15 V et 20 V, qui permet de stocker l'information sous forme de charges piégées dans la grille flottante.

Cependant, de telles mémoires présentent des inconvénients limitant la réduction de leurs dimensions. En effet, une réduction de l'épaisseur de l'oxyde tunnel (oxyde disposé entre le canal et la couche de polysilicium) entraîne une augmentation du SILC (« Stress Induced Leakage Current »). Or, l'utilisation prolongée d'une telle mémoire (répétition de cycles écriture - effacement) génère des défauts dans l'oxyde tunnel qui vont assister la conduction de charges et dégrader la rétention des charges dans la grille flottante, ce qui pose des problèmes dans le cas d'un SILC important. Dans la pratique, il est donc difficile de réduire l'épaisseur de l'oxyde tunnel de ces mémoires à moins de 8 nm sans que le SILC ne devienne un phénomène critique pour la mémorisation. De plus, en réduisant les dimensions d'une telle cellule mémoire, le couplage parasite entre les grilles flottantes de deux cellules adjacentes d'une même mémoire devient important et peut donc dégrader la fiabilité de la mémoire.

Pour ces raisons, des mémoires de type MONOS (Métal Oxyde Nitrure Oxyde Silicium), également appelées mémoires NROM, ont été proposées pour remplacer les mémoires à grille flottante en polysilicium. Le document US5768192 décrit de telles mémoires dans lesquelles les charges électriques sont stockées dans des pièges formés dans une grille flottante composée de nitrure et disposée entre deux couches d'oxyde. Dans une telle couche de nitrure, les pièges sont isolés les uns des autres. Ainsi, un électron stocké dans un des pièges reste localisé physiquement dans ce piège, ce qui rend ces mémoires beaucoup plus « résistantes » aux défauts dans l'oxyde tunnel, et donc moins impactées par une augmentation du SILC. En effet, en présence d'un défaut dans l'oxyde tunnel, la couche de mémorisation, c'est-à-dire la couche de nitrure, perd uniquement les électrons situés dans l'entourage proche du défaut, les autres électrons piégés n'étant pas affectés par ce défaut. Ces mémoires disposent donc d'une meilleure fiabilité. Il est ainsi possible d'avoir un oxyde tunnel d'épaisseur inférieure à environ 8 nm, et donc de réduire les tensions de programmation nécessaires. De plus, du fait de la faible épaisseur du nitrure pour former la couche de mémorisation, le couplage entre deux cellules mémoires adjacentes est fortement réduit par rapport à des cellules à grille flottante en polysilicium. Enfin, la structure d'une mémoire de type NROM est également adaptée pour réaliser des mémoires embarquées en raison de la simplicité du procédé d'intégration de ces mémoires.

Le document de S. Kianian et al., « A novel 3 volts-only, small sector erase, high density flash E2PROM » (Technical Digest of VLSI Technology, 1994, p.71) décrit un autre type de mémoire, appelée mémoire « split-gate », qui comporte au sein d'une même cellule mémoire un transistor de mémorisation et un transistor de sélection (ou transistor de commande) formés sur une unique zone active. Une telle cellule mémoire à double grille est généralement programmée par injection de porteurs par la source (« source side injection » en anglais), mécanisme qui requiert justement la présence d'un transistor de sélection accolé au transistor de mémorisation, et qui permet d'augmenter la vitesse de programmation tout en réduisant la consommation par rapport à une mémoire de type NROM.

Afin de bénéficier des avantages de chaque structure, split-gate et NROM, le document US2004/207025A1 propose un autre type de mémoire à double grille combinant la structure d'une mémoire de type NROM avec une architecture split-gate. Une des difficultés pour réaliser ces mémoires concerne le contrôle de la position des grilles (grille du transistor de commande et grille du transistor de mémorisation) l'une par rapport à l'autre.

En effet, ces grilles sont réalisées par deux photolithographies successives, le désalignement de la seconde grille par rapport à la première grille fixant la longueur de la seconde grille. Un mauvais contrôle des positions relatives des deux grilles se traduit donc par un mauvais contrôle des caractéristiques électriques du second transistor, et donc potentiellement de mauvaises performances de la mémoire. Par conséquent, un contrôle très précis de la position des grilles est nécessaire lors de la réalisation de ce type de mémoire.

Afin de s'affranchir de cette contrainte d'alignement, le document US7130223B2 propose de réaliser une mémoire à double grille combinant la structure d'une mémoire de type NROM avec une architecture split-gate et dans laquelle la grille du transistor de mémorisation, c'est-à-dire la grille comportant la couche de mémorisation de données, est réalisée sous la forme d'un espaceur latéral de la grille du transistor de commande, disposé contre un des deux flancs latéraux de la grille du transistor de commande. Une telle structure permet de contrôler précisément la position et la dimension de la grille du transistor de mémorisation par rapport à la grille du transistor de commande car, du fait que la grille du transistor de mémorisation soit réalisée sous la forme d'un espaceur latéral, celle-ci est donc auto-alignée par rapport à la grille du transistor de commande.

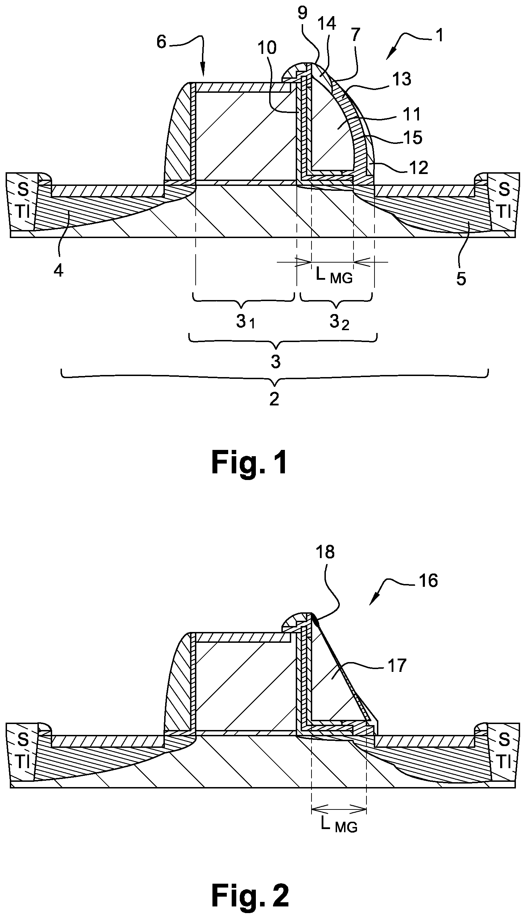

Une telle structure est illustrée par la figure 1 qui représente schématiquement une mémoire 1 à double grille combinant la structure d'une mémoire de type NROM avec une architecture split-gate dans laquelle la grille du transistor de mémorisation est réalisée sous la forme d'un espaceur latéral de la grille du transistor de commande. La mémoire 1 comporte une zone active de canal 2 réalisée dans un matériau semi-conducteur et comportant un canal 3 disposé entre une région d'extension de drain 4 et une région d'extension de source 5. La mémoire 1 comporte en outre une grille de transistor de sélection 6 surmontant une première partie 3₁ du canal 3 et un espaceur latéral 7 disposé contre le flanc latéral de la grille du transistor de sélection 6.

Cet espaceur latéral 7 forme la grille du transistor mémoire 9 surmontant la seconde partie 3₂ du canal 3. Ce transistor mémoire 9 comporte notamment :
- un empilement tri-couches diélectrique d'oxyde-nitrure-oxyde (dit empilement ONO) 10, la couche de nitrure servant à stocker les charges électriques;
- une zone conductrice 11 de grille du transistor mémoire en polysilicium présentant un flanc latéral 15 sensiblement arrondi ;
- des couches d'espaceurs fins localisées sur la partie arrondie de la zone conductrice 11, par exemple en oxyde à haute température (« High Thermal Oxide » en anglais) HTO (couche 13) et en nitrure Si₃N₄ (couche 12). On retrouve ces couches d'espaceurs fins sur la partie opposée du transistor de sélection.

L'espaceur latéral 7 permet à la fois d'isoler la grille du transistor de sélection 6 des zones de drain mais aussi de former la grille du transistor mémoire 9 via l'empilement ONO 10.

Toutefois, avec une telle structure, il est très difficile de réaliser ensuite une reprise de contact électrique sur la grille du transistor de mémorisation 9 compte tenu des faibles dimensions de cette grille en forme d'espaceur latéral. Cette reprise de contact est par exemple illustrée par la zone de siliciuration 14 située en haut du flanc latéral arrondi 15. On constate que la zone permettant la siliciuration est relativement réduite. Cette difficulté est encore accentuée du fait que les flancs obtenus par les procédés standards sont plutôt de forme triangulaire ; il est en effet très difficile d'obtenir par gravure directe une forme arrondie permettant d'obtenir une surface de siliciuration suffisante. Une telle architecture 16 est illustrée en figure 2. La mémoire 16 est identique à la mémoire 1 mais présente une zone conductrice 17 de forme triangulaire sur laquelle la zone de siliciuration 18 encore plus limitée que dans le cas de la figure 1.

En outre, l'article « Scalability of split-gate charge memories down to 20nm for low-power embedded memories » (Masoero et al. - Electron Devices Meeting (IEDM) - 2011) a démontré que la diminution de la longueur de grille mémoire L_{MG} (i.e. la longueur de la zone conductrice 17 de grille du transistor mémoire la plus proche du canal 3 et mesurée suivant la longueur du canal 3 - cf. figure 1) permet d'améliorer les performances électriques de la mémoire telles que la fenêtre de programmation ou l'énergie consommée. On conçoit aisément qu'une telle diminution de la longueur de grille rend encore plus délicate la réalisation d'une zone de contact importante au niveau de la grille du transistor mémoire.

Les documents US2006/028868 et US2009/103355 décrivent également de telles mémoires de type NROM avec une architecture « split gate ».

Le document US2006/028868 décrit les caractéristiques du préambule de la revendication 1. L'invention vise à remédier aux inconvénients de l'état de la technique en proposant une cellule mémoire électronique de type NROM avec une architecture split-gate permettant à la fois d'obtenir une surface de reprise de contact (i.e. zone de siliciuration) satisfaisante tout en améliorant les performances électriques de ladite cellule mémoire.

Pour ce faire, l'invention propose une cellule mémoire électronique comportant :
- un substrat sur lequel est formée une zone active de canal réalisée dans un matériau semi-conducteur et comportant un canal disposé entre une région d'extension de drain et une région d'extension de source ;
- une première structure de grille, dite grille du transistor de sélection, surmontant une première partie dudit canal ;
- un espaceur latéral disposé contre au moins un flanc latéral de ladite grille du transistor de sélection, ledit espaceur latéral comprenant une deuxième structure de grille, dite grille du transistor mémoire, surmontant une seconde partie dudit canal, ladite grille du transistor mémoire comportant :
   ∘ un empilement de couches dont une desdites couches est adaptée pour stocker des charges électriques, ledit empilement incluant une première zone d'empilement en contact avec ladite seconde partie dudit canal et une seconde zone d'empilement en contact avec ledit flanc latéral de ladite grille du transistor de sélection ;
   ∘ une zone conductrice de grille du transistor mémoire incluant
      ▪ une première face latérale au contact de ladite seconde zone d'empilement de sorte que cette dernière sépare ledit flanc latéral de la grille du transistor de sélection et ladite première face latérale ;
      ▪ une face inférieure sensiblement plane et parallèle au plan du substrat, ladite face inférieure étant au contact de ladite première zone d'empilement de sorte que ladite première zone d'empilement sépare ladite seconde partie dudit canal et ladite face inférieure ;
      ▪ une face supérieure sensiblement plane et parallèle au plan du substrat ;
      ▪ une seconde face latérale, lesdites première et seconde faces latérales reliant ladite face inférieure à ladite face supérieure, ladite seconde face latérale étant inclinée d'un angle α strictement compris entre 0 et 90° par rapport au plan du substrat de sorte que la longueur de ladite face supérieure soit strictement supérieure à la longueur de ladite face inférieure, lesdites longueurs étant mesurées comme la distance entre lesdites première et seconde faces latérales suivant la longueur dudit canal.

Grâce à l'invention, on utilise avantageusement une seconde face latérale en biais présentant une inclinaison strictement comprise entre 0 et 90° par rapport au plan du substrat de sorte que l'écartement entre la première face latérale et la deuxième face latérale augmente continument de la zone la plus proche du canal vers la zone supérieure adaptée pour la réalisation de la siliciuration. On peut ainsi obtenir à la fois une longueur de grille mémoire faible permettant d'améliorer les performances électriques de la cellule (notamment en augmentant la fenêtre de programmation et en minimisant l'énergie consommée) tout en obtenant une surface de siliciuration importante et plane sur la partie supérieure de la zone conductrice de grille du transistor mémoire.

La cellule mémoire selon l'invention peut également présenter une ou plusieurs des caractéristiques ci-après, prises individuellement ou selon toutes les combinaisons techniquement possibles :
- l'angle α est avantageusement supérieur ou égal à 45°de sorte qu'on puisse plus aisément réaliser le dépôt des couches de diélectrique, par exemple en HTO (« High Thermal Oxide ») et Si₃N₄;
- l'angle α est compris entre 45° et 70°, par exemple 60° ;
- la couche adaptée pour stocker des charges électriques dudit empilement est disposée entre deux couches de matériau diélectrique dudit empilement ;
- ladite couche adaptée pour stocker des charges électriques est par exemple une couche de nitrure ou une couche comprenant des nanocristaux par exemple en silicium.
La présente invention a également pour objet un procédé de fabrication d'une cellule mémoire selon l'invention caractérisé en ce que la réalisation de la zone conductrice de grille du transistor mémoire présentant ladite seconde face latérale inclinée de l' angle α strictement compris entre 0 et 90° par rapport au plan du substrat comporte les étapes suivantes :
- dépôt d'une couche de matériau sacrificiel ;
- réalisation sur ladite couche de matériau sacrificiel d'un motif de résine comportant au moins un flanc incliné présentant un angle obtus d'inclinaison β par rapport au plan du substrat ;
- transfert de la forme dudit motif de résine dans la couche de matériau sacrificiel par gravure du matériau sacrificiel et de la résine de telle sorte qu'on obtienne un motif en matériau sacrificiel comportant au moins un flanc incliné présentant un angle obtus d'inclinaison β' par rapport au plan du substrat sensiblement égal à (180°- α) où α est l'angle aigu d'inclinaison recherchée de la seconde face latérale par rapport au plan du substrat ;
- dépôt conforme d'un matériau conducteur remplissant les espaces situés de part et d'autre du motif en matériau sacrificiel de sorte que le matériau conducteur épouse la forme du flanc incliné ;
- retrait d'une partie du matériau conducteur et de la totalité du matériau sacrificiel de façon à conserver la zone conductrice de grille du transistor mémoire réalisée dans ledit matériau conducteur et présentant une face latérale inclinée d'un angle α strictement compris entre 0 et 90° par rapport au plan du substrat, ladite face latérale correspondant, avant retrait du matériau sacrificiel, à la face de contact avec le flanc incliné du motif en matériau sacrificiel.

Le procédé de fabrication selon l'invention peut également présenter une ou plusieurs des caractéristiques ci-après, prises individuellement ou selon toutes les combinaisons techniquement possibles :
- la réalisation sur ladite couche de matériau sacrificiel d'un motif de résine comportant au moins un flanc incliné présentant un angle obtus d'inclinaison β est obtenue par une étape de lithographie et de fluage d'une couche de résine ;
- le procédé comporte les étapes suivantes préalables au dépôt d'une couche de matériau sacrificiel :
   ∘ formation du transistor de sélection ;
   ∘ dépôt de l'empilement de couches dont une desdites couches est adaptée pour stocker des charges électriques, le dépôt de la couche de matériau sacrificiel étant réalisé au-dessus des couches de l'empilement ;
- l'épaisseur de la couche de matériau sacrificiel est, au niveau de la zone de réalisation de la zone conductrice de grille du transistor mémoire, supérieure ou égale à l'épaisseur cumulée de la grille du transistor de sélection et des couches de l'empilement ;
- les vitesses de gravure de la résine et du matériau sacrificiel sont sensiblement identiques lors du transfert de la forme dudit motif de résine dans la couche de matériau sacrificiel par gravure du matériau sacrificiel et de la résine. Par exemple, avec un angle d'usinage de 40° par rapport à l'axe y de la plaquette à usiner, la vitesse de gravure de la résine est d'environ 13 nm/min et la vitesse de gravure du Si₃N₄ est de l'ordre de 12 nm/min.

D'autres caractéristiques et avantages de l'invention ressortiront à la lecture de la description qui suit, en référence aux figures annexées :
- la figure 1 représente schématiquement un premier exemple de mémoire à double grille selon l'état de technique combinant la structure d'une mémoire de type NROM avec une architecture split-gate ;
- la figure 2 représente schématiquement un second exemple de mémoire à double grille selon l'état de technique combinant la structure d'une mémoire de type NROM avec une architecture split-gate ;
- la figure 3 représente une cellule mémoire électronique de type NROM avec une architecture split-gate selon un mode de réalisation de l'invention ;
- la figure 4 représente une variante de la cellule mémoire électronique de type NROM de la figure 3 ;
- les figures 5a à 5l illustrent les différentes étapes d'un exemple de procédé de fabrication de la cellule mémoire de la figure 4.

Pour plus de clarté, les éléments identiques ou similaires sont repérés par des signes de référence identiques sur l'ensemble des figures.

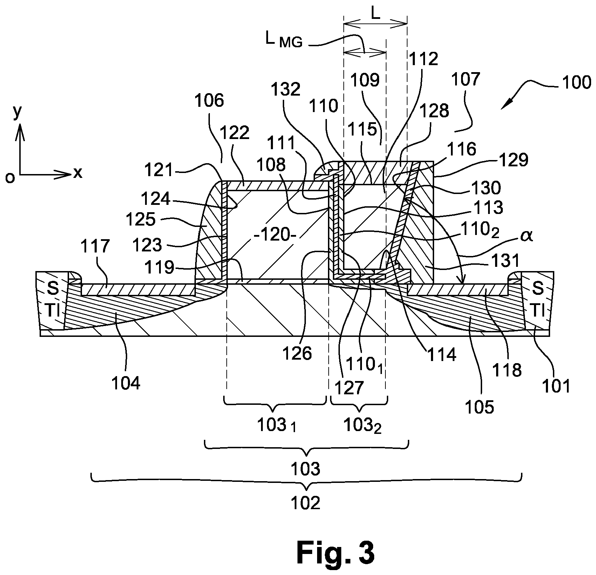

La figure 3 représente un exemple de mode de réalisation d'une cellule mémoire électronique 100 de type NROM avec une architecture split-gate selon l'invention.

La cellule 100 comporte un substrat 101 sur lequel est formée une zone active de canal 102 réalisée dans un matériau semi-conducteur et comportant un canal 103 disposé entre une région d'extension de drain 104 et une région d'extension de source 105. Dans le cas de la réalisation d'un transistor de type n sur un substrat 101 de type p, les régions d'extension de drain 104 et de source 105 sont dopées n+. Chaque région d'extension de drain 104 et de source 105 comporte en outre une siliciuration, respectivement 117 et 118, sur sa surface supérieure. Le substrat 101 est un substrat à base d'un semiconducteur tel que du silicium. La longueur du canal est ici représentée suivant un axe Ox parallèle au plan du substrat, l'axe Oy étant perpendiculaire au plan du substrat.

Conformément au principe des mémoires de type NROM à architecture split-gate à double grille, la mémoire 100 comporte deux structures de grilles disposées l'une à côté de l'autre :
- une première structure de grille, dite grille du transistor de sélection (ou grille du transistor de commande) 106 ;
- une seconde structure de grille, dite grille du transistor mémoire (ou grille du transistor de mémorisation) 109 réalisée sous la forme d'un espaceur latéral 107 de la grille du transistor de sélection 106.

Le canal 103 est sensiblement séparé en deux parties 103₁ et 103₂ côte à côte.

La grille du transistor de sélection 106 surmonte la première partie 103₁ tandis que la grille du transistor de mémorisation 109 surmonte la seconde partie 103₂.

La grille du transistor de sélection 106 comporte :
- une couche diélectrique de grille 119 (par exemple en Si0₂) au contact de la première partie 103₁ (l'épaisseur de cette couche diélectrique, mesurée suivant l'axe Oy, dépend du noeud technologique de la cellule mémoire 100 et est par exemple comprise entre 1 nm et 10nm);
- une zone conductrice de grille du transistor de sélection 120 (par exemple en polysilicium dopé n+) recouverte par une couche de siliciuration 122 ; l'épaisseur de cette zone conductrice 120 est par exemple égale à 50nm ;

La grille du transistor de sélection 106 est isolée du contact 118 de source 105 par un premier espaceur latéral 107 et du contact 117 de drain par un second espaceur latéral 121.

Plus précisément, la zone conductrice de grille du transistor de sélection 120 possède deux parois latérales 123 et 108 et chaque paroi latérale 123 et 108 est entièrement recouverte respectivement par les espaceurs 121 et 107.

Le second espaceur latéral 121 est un espaceur isolant s'étendant sur tout le flanc latéral (côté drain) et formé d'un matériau diélectrique, qui peut par exemple être un nitrure ou une bicouche oxyde/nitrure (par exemple, une couche 124 de SiO₂ HTO et une couche 125 de Si₃N₄).

Le premier espaceur latéral 107 est différent du second espaceur 121 dans la mesure où une partie de ce premier espaceur 107 forme la grille du transistor mémoire 109.

Le premier espaceur 107 comporte un empilement 110 tri-couches d'oxyde-nitrure-oxyde (dit ONO) formé d'une première couche diélectrique 126 (par exemple en SiO₂), d'une seconde couche 111 réalisée dans un matériau apte à stocker des charges électriques (par exemple composée de Si₃N₄) et d'une troisième couche 127 composée d'un matériau diélectrique (par exemple du SiO₂) ; la première couche 126 a par exemple une épaisseur comprise entre 3 et 8nm ; la seconde couche 111 a par exemple une épaisseur comprise entre 4 et 10nm et la troisième couche 127 a par exemple une épaisseur comprise entre 4 et 15nm.

L'empilement ONO 110 présente deux zones :
- une première zone d'empilement 110₁ sensiblement horizontale (i.e. avec une surface parallèle au plan du substrat 101) en contact avec la seconde partie 103₂;
- une deuxième zone d'empilement 110₂ sensiblement verticale (i.e. avec une surface perpendiculaire au plan du substrat 101).

La grille du transistor mémoire 109 inclut ledit empilement ONO 110 ainsi qu'une zone conductrice de grille du transistor mémoire 112 (par exemple en polysilicium dopé n+).

La zone conductrice 112 de grille du transistor mémoire présente :
- une première face latérale 113 au contact de la seconde zone d'empilement 110₂ de sorte que cette dernière sépare le flanc latéral 108 de la grille du transistor de sélection 106 et la première face latérale 113;
- une face inférieure 114 sensiblement plane et parallèle au plan du substrat 101 ; cette face inférieure 114 est au contact de la première zone 110₁ d'empilement de sorte que cette dernière est intercalée entre la seconde partie 103₂ du canal 103 et la face inférieure 114 de la zone conductrice 112 ;
- une face supérieure 115 sensiblement plane et parallèle au plan du substrat 101 ;
- une seconde face latérale 116 inclinée d'un angle α strictement compris entre 0 et 90° par rapport au plan du substrat 101 ; l'angle α est de préférence supérieur ou égal 45°, préférentiellement sensiblement égal à 60°.

Les première et seconde faces latérales 113 et 116 relient la face inférieure 114 à la face supérieure 115. Comme la seconde face latérale 116 forme un biais incliné d'un angle aigu α strictement compris entre 0 et 90° par rapport au plan du substrat 101, la distance entre les première et seconde faces latérales 113 et 116 va diminuer progressivement de la face supérieure 115 jusqu'à la face inférieure 114.

Ainsi, la longueur L de la face supérieure 115 est strictement supérieure à la longueur L_{MG} de la face inférieure 114, lesdites longueurs L et L_{MG} étant mesurées comme la distance entre la première face latérale 113 et la seconde face latérale 116. Cette distance est mesurée suivant la direction de la longueur du canal 103, c'est-à-dire suivant l'axe Ox.

On peut considérer en première approximation que L=L_{MG}+h/tgα où h désigne la hauteur du transistor mémoire.

Nous prendrons dans ce qui suit deux exemples, avec respectivement des angles α égaux à 60° et à 45°.

### 1/ Cas où α=60°

Dans le cas où L_{MG}= 20 nm et h=50 nm, on obtient L=20+h/√3 soit environ 50 nm.

Dans le cas où L_{MG}=200nm et h=50nm, on obtient L=200+h/√3 soit environ 230 nm.

Dans le cas où L_{MG}=200nm et h=100nm, on obtient L=200+h/√3 soit environ 260 nm.

Dans le cas où L_{MG}=500nm et h=100nm, on obtient L=500+h/√3 soit environ 560 nm.

### 2/ Cas où α=45°

Dans le cas où L_{MG}=20nm et h=50nm, on obtient L=20+50 soit 70 nm.

Dans le cas où L_{MG}=200nm et h=50nm, on obtient L=200+50 soit 250 nm.

Dans le cas où L_{MG}=200nm et h=100nm, on obtient L=200+100 soit 300 nm.

Dans le cas où L_{MG}=500nm et h=100nm, on obtient L=500+100 soit 600 nm.

De façon préférentiel, on choisira l'angle α petit pour avoir à la fois une longueur L grande et une longueur de grille mémoire L_{MG} petite (par exemple α=45°). D'après l'article cité précédemment « Scalability of split-gate charge memories down to 20nm for low-power embedded memories » (Masoero et al. - Electron Devices Meeting (IEDM) - 2011), la diminution de la longueur de grille mémoire L_{MG} (i.e. la longueur de la zone conductrice 17 de grille du transistor mémoire la plus proche du canal 3 et mesurée suivant la longueur du canal 3 - cf. figure 1) permet d'améliorer les performances électriques de la mémoire telles que la fenêtre de programmation ou l'énergie consommée. Nous recherchons donc la longueur de grille mémoire L_{MG} la plus petite possible. Ainsi, on prendra, selon un mode de réalisation préférentiel, α=45° et L_{MG} compris entre 20 nm et 80 nm.

Une couche de contact 128 est par ailleurs réalisée sur la face supérieure 115 par siliciuration.

La longueur L_{MG} correspond à la longueur de grille mémoire, c'est-à-dire la longueur de la zone de grille mémoire la plus proche de la seconde partie 103₂ du canal 103.

Comme évoqué précédemment, les performances électriques de la cellule 100 sont améliorées lorsqu'on diminue la longueur de grille du transistor mémoire. La cellule 100 selon l'invention permet donc de diminuer la longueur de grille mémoire L_{MG} tout en ayant une longueur L sur la face supérieure 115 de la zone conductrice 112 plus importante de sorte que la surface pour réaliser le contact soit plus importante.

La forme biseautée de la zone conductrice 112 de la grille du transistor mémoire (via la seconde face latérale 116 inclinée) permet donc d'avoir une surface 115 de siliciuration importante et d'avoir une reprise contact optimale tout en minimisant la longueur de grille mémoire L_{MG}.

La seconde face latérale 116 inclinée est également recouverte d'un espaceur isolant 129 s'étendant sur tout le flanc latéral (côté source) et formé d'un matériau diélectrique, qui peut par exemple être un nitrure ou une bicouche oxyde/nitrure (par exemple, une couche 130 de SiO₂ HTO et une couche 131 de Si₃N₄). Cet espaceur isolant 129 permet d'isoler la grille 107 du transistor mémoire de la source 105.

De plus, il a également pour fonction d'« espacer » les zones dopées (source et drain), qui s'élargissent pendant le recuit et pourraient donc se rejoindre et provoquer un court-circuit.

On notera également que le flanc latéral de la surface supérieure 115 (recouverte par la siliciuration 128) est également recouverte d'un espaceur isolant 132 s'étendant sur tout le flanc latéral (du côté de la grille du transistor de sélection 106) et formé d'un matériau diélectrique, qui peut de la même façon que précédemment, être un nitrure ou une bicouche oxyde/nitrure. Cet espaceur isolant 132 permet d'isoler les surfaces de siliciuration 128 et 122 appartenant respectivement à la grille 107 du transistor mémoire et à la grille 106 du transistor de sélection.

Cet espaceur isolant 132 n'est pas forcément indispensable car l'empilement de couches 110 isole déjà la grille 106 du transistor de sélection et la grille 107 du transistor mémoire. Cette dernière configuration peut se produire par exemple si le haut de la grille 107 du transistor mémoire est à peu près au même niveau que le haut de la grille 106 du transistor de sélection. Cependant, l'espaceur isolant 132 contribue à renforcer l'isolation entre deux grilles.

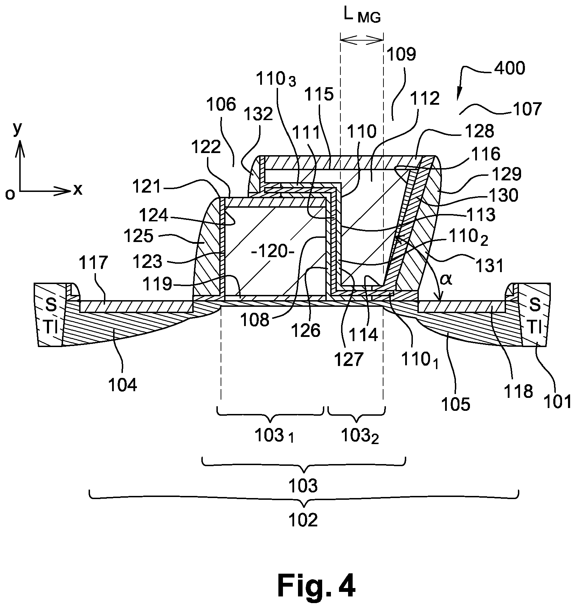

La figure 4 représente une variante 400 de la cellule mémoire électronique de type NROM avec une architecture split-gate de la figure 3. Les cellules 100 et 400 comportent les mêmes caractéristiques (illustrées avec les mêmes références sur la figure 4).

La cellule 400 se différencie de la cellule 100 en ce que l'empilement ONO 110 présente une troisième zone d'empilement 110₃ supérieure et parallèle à la première zone d'empilement 110₁ (i.e. avec une surface parallèle au plan du substrat 101). Cette troisième zone 110₃ s'arrête sensiblement à mi- longueur de la surface de siliciuration 122 de la grille du transistor de sélection 106. Dans le cas de la cellule 400, la zone conductrice 112 (ainsi que la surface de siliciuration 128) se prolonge sur la face supérieure de la troisième zone d'empilement 110₃ de sorte que l'on obtient encore davantage de surface de siliciuration.

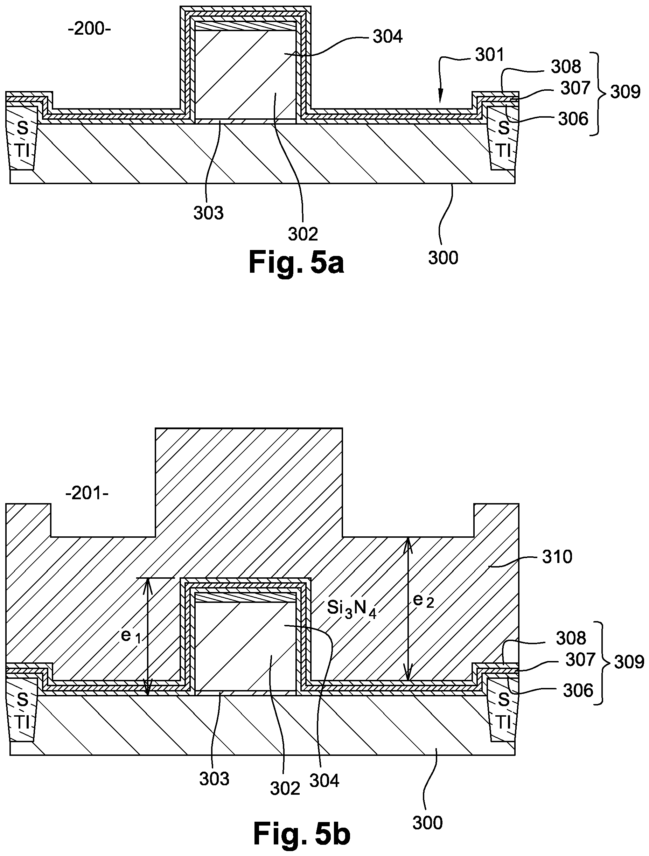

Les figures 5a à 5l illustrent les différentes étapes d'un exemple de procédé de fabrication de la cellule mémoire de la figure 4.

Selon la première étape 200 illustrée en figure 5a, on commence par réaliser dans une cavité 301 formée dans le substrat 300 une grille du transistor de sélection 302 composée d'une couche diélectrique de grille 303 (réalisée par exemple par oxydation thermique de la zone semi-conductrice) suivie d'une couche conductrice 304 en polysilicium.

On réalise ensuite le dépôt d'un empilement tri-couches 309 d'oxyde-nitrure-oxyde (dit ONO) formé d'une première couche diélectrique 306 (par exemple en SiO₂), d'une seconde couche 307 réalisée dans un matériau apte à stocker les charges électriques (par exemple composée de Si₃N₄) et d'une troisième couche 308 composée d'un matériau diélectrique (par exemple du SiO₂). Ce dépôt peut être réalisé par dépôt conforme de manière à recouvrir la grille 302.

Selon une seconde étape 201 illustrée en figure 5b, on dépose une couche 310 de matériau sacrificiel, par exemple du Si₃N₄. Une condition pour obtenir la seconde face latérale 116 inclinée telle que représentée en figures 3 et 4 est de déposer, au moins dans la zone de réalisation de cette seconde face latérale 116 inclinée, le matériau sacrificiel sur une épaisseur e2 supérieure ou égale à l'épaisseur cumulée e1 de la couche diélectrique de grille 303, de la couche conductrice 304 en polysilicium et de l'empilement tri-couches 309 d'ONO. Cette épaisseur e2 est par exemple supérieure ou égale à 80 nm.

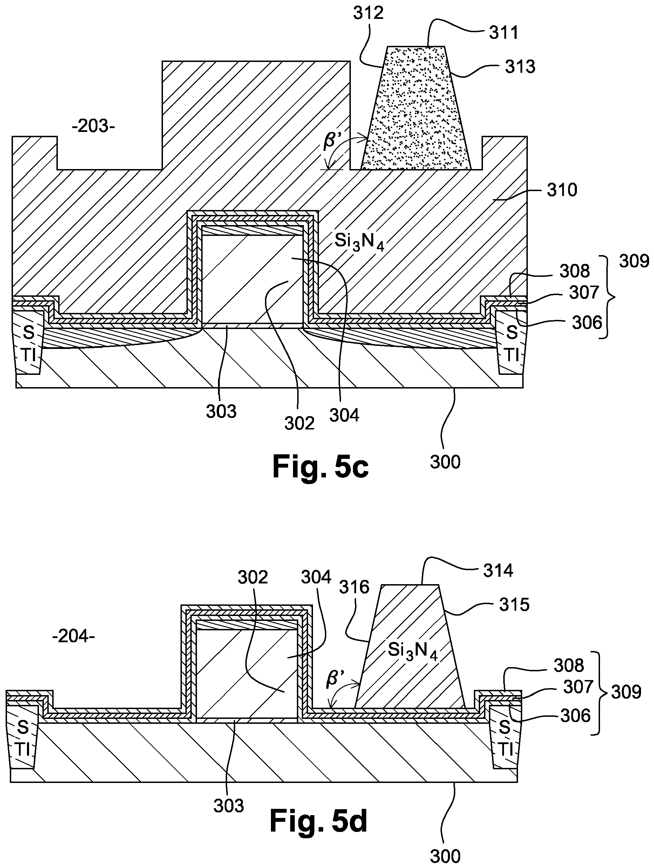

Selon une troisième étape 203 illustrée en figure 5c, on réalise un motif de résine fluée 311 au niveau de la zone de réalisation de la seconde face latérale 116 inclinée. Ce motif de résine 311 est de forme sensiblement trapézoïdale et est formé de sorte que ses flancs inclinés 312 et 313 présentent un angle obtus d'inclinaison β par rapport au plan du substrat 300.

Ce type de motif 311 peut être notamment obtenu en utilisant une résine de type « Deep UV» telle qu'une résine M78y étalée sur une épaisseur d'environ 500nm puis lithographiée.

On insole (par exemple par des rayonnements UV) une fraction de la résine au-travers d'un masque comportant une partie transparente aux rayonnements UV à longueurs d'onde courtes (typiquement comprises entre 150 et 300nm) et une partie opaque aux rayonnements UV (absorbant les rayonnements UV) ; il se créé alors, par réaction photochimique, une image latente dans l'épaisseur de la résine photosensible.

La résine est ensuite « développée » en utilisant des « développeurs » tels le TMAH par exemple (TétraMéthyl Ammoniac Hydroxyle). Un recuit final (« post bake» ou «hard bake») est appliqué pour durcir les motifs de résine ainsi formés. Après ces étapes de développement et de recuit, une température comprise entre 20°C et 40°C au-dessus de la température de transition vitreuse Tg est appliquée afin de faire « fluer » la résine. Les paramètres de température de fluage et de durée de fluage permettent de régler l'angle β voulu.

A titre d'exemple purement illustratif, en utilisant une résine DUV appelée M78y, d'épaisseur 570 nm, on obtiendra un angle α d'environ 53° pour les conditions ci-après: Température de fluage=165°C (Tg de la résine=145°C), durée de fluage = 15 minutes, énergie = 30 mJ/cm². Une résine de type ebeam pourrait également être utilisée.

Selon une troisième étape 204 illustrée en figure 5d, on transfère la forme du motif de résine 311 dans la couche sacrificielle 310.

Ce transfert est obtenu en effectuant une gravure plasma (gravure sèche) telle qu'une gravure ionique réactive RIE sélective (« Reactive-Ion Etching ») de la couche de matériau sacrificiel 310 avec arrêt sur l'empilement ONO 309. Lors d'une gravure RIE, on va attaquer non seulement le matériau sacrificiel 310 (ici Si₃N₄) mais également le motif de résine 311. En prenant une vitesse de gravure de la résine sensiblement identique à la vitesse de gravure du matériau sacrificiel, on comprend que la forme de la résine va se retrouver transférée dans le matériau sacrificiel de sorte qu'on retrouve un motif 314 en matériau sacrificiel (Si₃N₄) de forme identique à celle du motif de résine 311 sur l'empilement ONO 309 au niveau de la zone de réalisation de la seconde face latérale 116 inclinée. Ce motif 314 en matériau sacrificiel (Si₃N₄) est donc de forme sensiblement trapézoïdale et est formé de sorte que ses flancs inclinés 315 et 316 présentent un angle obtus d'inclinaison β' par rapport au plan du substrat 300 sensiblement égal à (180°- α) où α est l'angle aigu d'inclinaison recherchée de la seconde face latérale 116.

Si l'on utilise un procédé de gravure nitrure « standard » en microélectronique par exemple sur une machine de gravure appelée Centura AP™, nous avons une vitesse de gravure du Si₃N₄ de l'ordre de 1100 À/min, et une vitesse de gravure de la résine M78y de l'ordre de 620 À/min, soit un facteur de sélectivité de gravure entre le nitrure et la résine de 1,8 environ, ce qui signifie que dans ces conditions de gravure, le nitrure se grave 1,8 fois plus vite que la résine M78y. Par voie de conséquence, l'angle β' sera tel que: tgβ'=1,8*tgβ. Si l'on utilise ces conditions de gravure, l'angle β est donc ajusté en fonction de l'ange β' visé.

De façon générale, on a : tgβ'=(vitesse de gravure du matériau sacrificiel/vitesse de gravure de la résine choisie)*tgβ. Le nitrure a été décrit comme matériau sacrificiel mais il est entendu que d'autres matériaux ayant pour caractéristiques un bon arrêt au polissage mécano-chimique et un retrait sélectif par rapport au silicium polycristallin peuvent également être utilisés.

On réalise alors un dépôt conforme de polysilicium 317, par exemple par un dépôt chimique à phase vapeur basse pression LPCVD (« Low Pressure Chemical Vapour Déposition »).

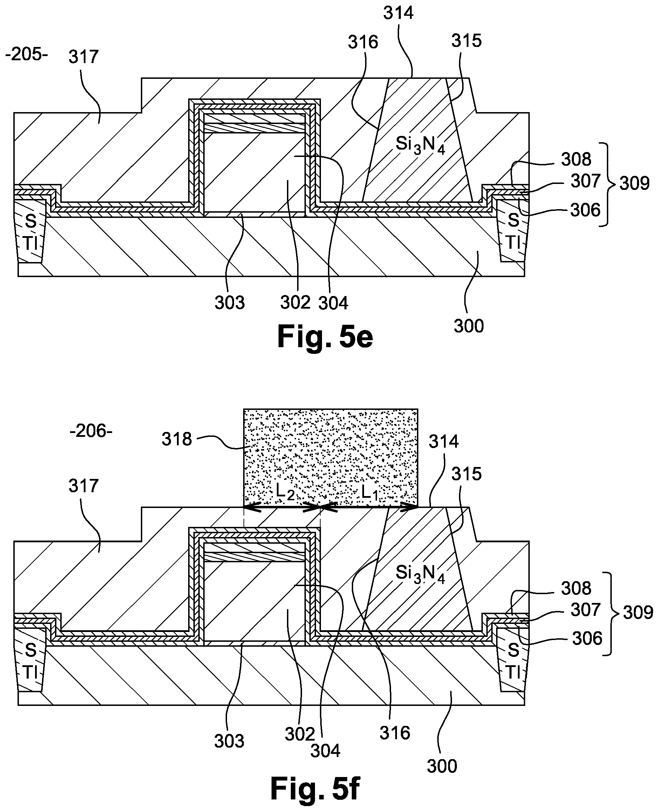

Suite à ce remplissage de polysilicium, selon une étape 205 illustrée en figure 5e, on effectue une étape de planarisation par polissage mécano-chimique, dit également CMP (« Chemical Mechanical Polishing »), de la couche de polysilicium 317 avec arrêt sur la surface supérieure du motif 314 de Si₃N₄.

Selon une étape 206 illustrée en figure 5f, on réalise un motif de résine 318. La géométrie de ce motif 318 est choisie de façon à protéger la partie de la couche de polysilicium 317 destinée à former la zone conductrice 112 de grille du transistor mémoire. Dans le cas de la figure 5f, le motif est positionné sur une longueur L1+L2 de sorte qu'on va obtenir une zone conductrice telle que celle présentée sur la cellule mémoire 400 de la figure 4. Un motif de résine 318 positionné uniquement sur la longueur L1 permettrait d'obtenir une zone conductrice en polysilicium telle que celle présentée sur la cellule mémoire 100 de la figure 3.

Ce type de motif 318 peut être notamment obtenu en utilisant une résine M78y (résine « deep UV») d'épaisseur 570 nm ou bien de type NEB22 (résine de type ebeam par exemple) étalée sur une épaisseur d'environ 200 nm par exemple puis lithographiée.

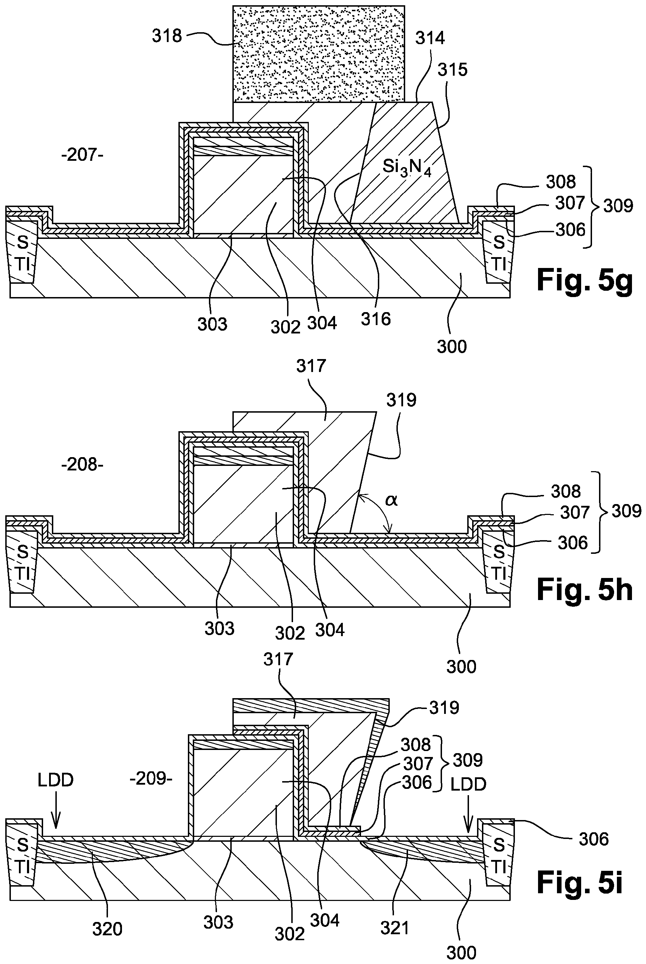

Selon une étape 207 illustrée en figure 5g, on réalise une étape de retrait sélectif, par exemple par gravure plasma (gravure sèche) telle une gravure ionique réactive RIE, du polysilicium non protégé par le motif de résine 318. Cette gravure est réalisée avec arrêt sur l'empilement ONO 309.

Selon l'étape 208 illustrée en figure 5h, on réalise une étape de retrait de la résine 318 (étape de stripping) puis du motif 314 de matériau sacrificiel (ou inversement). Ce retrait est effectué sélectivement par rapport à la couche 308 de SiO₂ de l'empilement ONO 309 et par rapport au silicium polycristallin 319 de grille du transistor mémoire. Ce retrait peut être réalisé par exemple en utilisant une gravure de type RIE. On constate ici que la couche de polysilicium 317 possède une face latérale 319 inclinée d'un angle α strictement compris entre 0 et 90° par rapport au plan du substrat 300. Cette face latérale 319 forme la seconde face latérale 116 (cf. figures 3 et 4) de la zone conductrice de grille du transistor mémoire de la cellule selon l'invention. On comprend l'intérêt d'avoir un angle α qui est de préférence supérieur ou égal 45° de manière à pouvoir retirer efficacement l'ensemble du matériau sacrificiel 314 ; si l'angle α est trop aigu, l'étape de retrait de la totalité du matériau sacrificiel peut être rendue plus difficile.

Selon l'étape 209 illustrée en figure 5i, on réalise le retrait des deux premières couches 308 et 307 de l'empilement 309 non recouvert avec arrêt sur la couche 306. Dans le cas d'un empilement 309 de type ONO, ce retrait peut être réalisé par gravure anisotrope plasma (gravure sèche) telle qu'une gravure ionique réactive RIE avec arrêt sur la couche de SiO₂ 306. L'étape 209 inclut ensuite une étape d'implantation de manière à commencer le dopage des zones d'extension de source et de drain. Ce dopage est un dopage de type LDD (« Low Doped Drain ») permettant de doper les régions d'extension de source 321 et de drain 320 à dose moyenne.. Selon que le transistor que l'on souhaite réaliser est du type PMOS ou NMOS, les ions sont choisis de façon à réaliser des zones d'un type de conductivité p ou n. On notera que l'implantation LDD se fait à-travers une partie de la couche 306 qui protège la surface de la zone semi-conductrice du substrat 300 à doper.

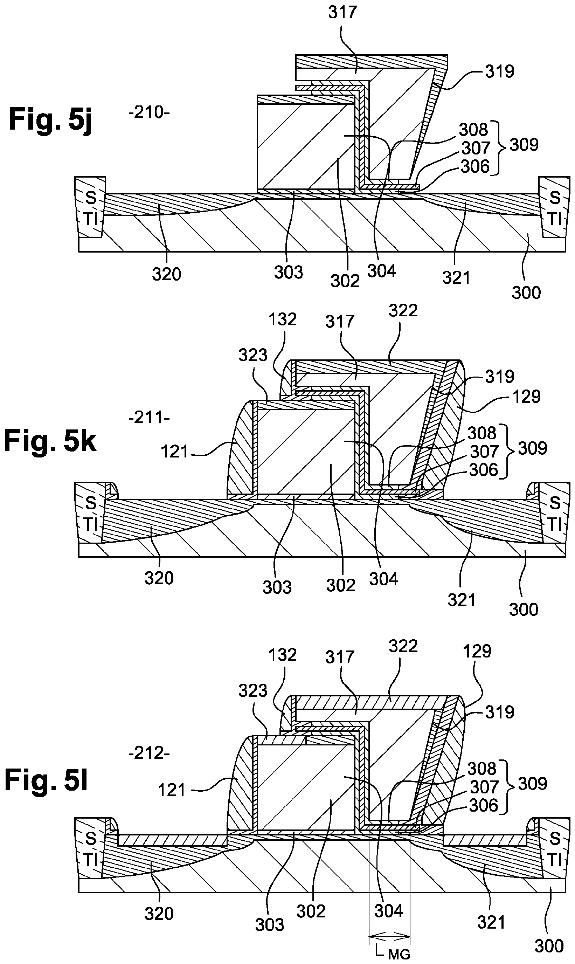

Selon l'étape 210 illustrée en figure 5j, on réalise le retrait de la couche inférieure 306 de l'empilement ONO 309. Ce retrait est par exemple réalisé par gravure humide isotrope avec une solution partiellement diluée d'acide fluorhydrique (HF) de manière à avoir une bonne sélectivité du retrait de SiO2 par rapport au substrat 300 (ici substrat silicium).

Selon l'étape 211 illustrée en figure 5k, on réalise les différents espaceurs isolants des cellules mémoires 100 ou 400, à savoir :
- le second espaceur latéral 121 s'étendant sur tout le flanc latéral (côté drain) ;
- l'espaceur isolant 129 s'étendant sur tout le flanc latéral (côté source) ;
- l'espaceur isolant 132 s'étendant sur tout le flanc latéral (du côté de la grille du transistor mémoire).

Chacun de ces espaceurs est formé d'un matériau diélectrique, qui peut par exemple être une bicouche oxyde/nitrure (par exemple, une couche de SiO₂ HTO et une couche de Si₃N₄).

Pour ce faire, on commence par déposer une première couche d'oxyde dite HTO obtenue par exemple par dépôt LPCVD. Typiquement, une épaisseur de 10 nm est déposée. En tout état de cause, cette épaisseur doit être suffisante pour combler les vides résultant de la gravure isotrope des couches d'oxyde de l'empilement de couches ONO intervenue précédemment. Cette couche permet une bonne accroche de la couche de Si₃N₄ déposée par la suite, et remplit également le rôle de couche d'arrêt à la gravure du Si₃N₄.

On réalise ensuite le dépôt d'une autre couche, par exemple une couche de nitrure de silicium (Si₃N₄). Ce dépôt peut être réalisé par la même technique que ci-dessus, c'est-à-dire via un dépôt chimique en phase vapeur à basse pression LPCVD. On dépose une couche de nitrure de silicium qui est typiquement comprise dans une gamme d'épaisseur allant de 20 nm et 40 nm. Cette couche de nitrure de silicium va permettre de former les « espaceurs nitrure » dont le rôle est d' « espacer » les zones d'implantation correspondant aux source/drain (car celles-ci pourraient se rejoindre lors du recuit qui suit l'implantation).

Les espaceurs sont obtenus par gravure de type RIE. On grave de manière anisotrope les couches de matériau isolant précédemment déposées de manière à conserver les parties verticales de ces couches de matériau isolant et à supprimer les parties horizontales de ces couches. La gravure doit être suffisante pour dégager la partie supérieure des couches surmontant les zones de polysilicium 320, 321, 322 et 323, les zones 320 et 321 servant respectivement de de reprise de contact pour le drain et pour la source, et les zones 322 et 323 servant respectivement de reprise de contact sur la grille du transistor de mémorisation (zone 322) et sur la grille du transistor de sélection (zone 323) ; ces zones peuvent être siliciurées pour assurer un bon contact électrique.

Toujours sur cette même figure 5k, après la réalisation des espaceurs 121, 129 et 132, on réalise le dopage des régions d'extension de source 321 et de drain 320 à plus forte énergie approximativement dans l'alignement des espaceurs ; cette implantation se rajoute à l'implantation à plus faible énergie LDD (Low Doped Drain) qui est réalisée dans l'alignement des grilles. Ce dopage est réalisé par implantation ionique des régions d'extension de source 321 et de drain 320. Ainsi, dans le cas de la réalisation d'un transistor n-MOS sur un substrat 300 de type p, les régions d'extension de source 321 et de drain 320 sont dopées n+. Afin d'activer les atomes dopants et de guérir les défauts dus au bombardement, on réalise ensuite un recuit d'implantation (dit également recuit d'activation).

Selon l'étape 212 illustrée en figure 5l, on réalise une étape de siliciuration qui correspond à la métallisation de la surface supérieure des couches de polysilicium 322 et 323 par réaction chimique entre le silicium et un métal (par exemple du nickel) de façon à former une zone de faible résistivité.

Afin de minimiser la résistance des régions d'extension de drain 320 et de source 321 réalisées en silicium monocristallin dopé, on effectue également une étape de siliciuration de ces zones ; la siliciuration correspond à la métallisation de ces zones de drain et de source par réaction chimique entre le silicium et un métal (par exemple du nickel) de façon à former des zones de faible résistivité. La structure illustrée en figure 5l est identique à la cellule mémoire 400 illustrée en figure 4.

Naturellement, l'invention n'est pas limitée aux modes de réalisation décrits en référence aux figures et des variantes peuvent être envisagées sans sortir du cadre de l'invention.

En particulier, l'invention a été plus spécifiquement décrite dans le cas d'un empilement de type ONO ; l'invention s'applique également à tout type de mémoire à couche de piégeage discrète sur architecture split-gate, les électrons pouvant être stockés dans une couche de nitrure (ONO) mais aussi dans une couche en nanocristaux.

De même, les modes de réalisation décrits concernaient des couches diélectriques de grille de type SiO₂ ou SiO₂ HTO mais il est entendu que d'autres types de diélectriques peuvent être utilisés, par exemple des diélectriques de type « high-k » tels que du Al₂O₃ en contact avec la région conductrice de la grille de mémorisation. On entend par matériau high-k ou matériau diélectrique à forte constante diélectrique un matériau ayant une constante diélectrique k strictement supérieure à 3.9 (constante diélectrique du dioxyde de silicium).

En particulier dans le cas d'une utilisation d'un matériau diélectrique high-k, il est également possible de remplacer le matériau conducteur en polysilicium des zones conductrices de grille par des matériaux métalliques afin de diminuer le travail de sortie.

## Revendications

1. Cellule mémoire électronique (100, 400) comportant :
- un substrat (101) sur lequel est formée une zone active de canal (102) réalisée dans un matériau semi-conducteur et comportant un canal (103) disposé entre une région d'extension de drain (104) et une région d'extension de source (105) ;
- une première structure de grille, dite grille de sélection (106), surmontant une première partie (103₁) dudit canal (103) ;
- un espaceur latéral (107) disposé contre au moins un flanc latéral (108) de ladite grille du transistor de sélection (106), ledit espaceur latéral (107) comprenant une deuxième structure de grille, dite grille du transistor mémoire (109), surmontant une seconde partie (103₂) dudit canal (103), ladite grille du transistor mémoire (109) comportant :
∘ un empilement (110) de couches dont une desdites couches (111) est adaptée pour stocker des charges électriques, ledit empilement (110) incluant une première zone (110₁) d'empilement en contact avec ladite seconde partie dudit canal (103₂) et une seconde zone d'empilement (110₂) en contact avec ledit flanc latéral (108) de ladite grille du transistor de sélection (106) ;
∘ une zone conductrice (112) de grille du transistor mémoire incluant
▪ une première face latérale (113) au contact de ladite seconde zone d'empilement (110₂) de sorte que cette dernière sépare ledit flanc latéral (108) de la grille du transistor de sélection (106) et ladite première face latérale (113);
▪ une face inférieure (114) sensiblement plane et parallèle au plan du substrat (101), ladite face inférieure (114) étant au contact de ladite première zone (110₁) d'empilement de sorte que ladite première zone (110₁) d'empilement sépare ladite seconde partie (103₂) dudit canal (103) et ladite face inférieure (114) ;
▪ une face supérieure (115) sensiblement plane et parallèle au plan du substrat (101) ;
▪ une seconde face latérale (116), lesdites première et seconde faces latérales (113, 116) reliant ladite face inférieure (114) à ladite face supérieure (115),
ladite cellule mémoire électronique étant **caractérisée en ce que** ladite seconde face latérale (116) est inclinée d'un angle α strictement compris entre 0 et 90° par rapport au plan du substrat (101) de sorte que la longueur (L) de ladite face supérieure (115) soit strictement supérieure à la longueur (L_{MG}) de ladite face inférieure (114), lesdites longueurs (L, L_{MG}) étant mesurées comme la distance entre lesdites première (113) et seconde (116) faces latérales suivant la longueur dudit canal (103).

2. Cellule mémoire selon la revendication 1 **caractérisée en ce que** l'angle α est supérieur ou égal à 45°

3. Cellule mémoire selon la revendication précédente **caractérisé en ce que** l'angle α est compris entre 45° et 70°.

4. Cellule mémoire selon l'une des revendications précédentes **caractérisé en ce que** la couche adaptée pour stocker des charges électriques dudit empilement est disposée entre deux couches de matériau diélectrique dudit empilement.

5. Cellule mémoire selon l'une des revendications précédentes **caractérisé en ce que** ladite couche adaptée pour stocker des charges électriques est une couche de nitrure ou une couche comportant des nanocristaux tels que des nanocristaux silicium.

6. Procédé (200) de fabrication d'une cellule mémoire selon l'une des revendications précédentes **caractérisé en ce que** la réalisation de la zone conductrice de grille du transistor mémoire présentant ladite seconde face latérale inclinée dudit angle α strictement compris entre 0 et 90° par rapport au plan du substrat comporte les étapes suivantes :
- dépôt d'une couche de matériau sacrificiel (201) ;
- réalisation (203) sur ladite couche de matériau sacrificiel d'un motif de résine comportant au moins un flanc incliné présentant un angle obtus d'inclinaison β par rapport au plan du substrat ;
- transfert (204) de la forme dudit motif de résine dans la couche de matériau sacrificiel par gravure du matériau sacrificiel et de la résine de telle sorte qu'on obtienne un motif en matériau sacrificiel comportant au moins un flanc incliné présentant un angle obtus d'inclinaison β' par rapport au plan du substrat sensiblement égal à (180°- α) où α est l'angle aigu d'inclinaison recherchée de la seconde face latérale ;
- dépôt (205) conforme d'un matériau conducteur remplissant les espaces situés de part et d'autre du motif en matériau sacrificiel de sorte que le matériau conducteur épouse la forme du flanc incliné ;
- retrait (206, 207, 208) d'une partie du matériau conducteur et de la totalité du matériau sacrificiel de façon à conserver la zone conductrice de grille du transistor mémoire réalisée dans ledit matériau conducteur et présentant une face latérale inclinée d'un angle α strictement compris entre 0 et 90° par rapport au plan du substrat, ladite face latérale correspondant, avant retrait du matériau sacrificiel, à la face de contact avec le flanc incliné du motif en matériau sacrificiel.

7. Procédé selon la revendication précédente **caractérisé en ce que** la réalisation (203) sur ladite couche de matériau sacrificiel d'un motif de résine comportant au moins un flanc incliné présentant un angle obtus d'inclinaison β est obtenue par une étape de lithographie et de fluage d'une couche de résine.

8. Procédé selon l'une des revendications 6 ou 7 **caractérisé en ce que** le procédé comporte les étapes suivantes préalables au dépôt d'une couche de matériau sacrificiel :
- formation (200) du transistor de sélection ;
- dépôt (200) de l'empilement de couches dont une desdites couches est adaptée pour stocker des charges électriques, le dépôt de la couche de matériau sacrificiel étant réalisé au-dessus des couches de l'empilement.

9. Procédé selon la revendication précédente **caractérisé en ce que** l'épaisseur de la couche de matériau sacrificiel est, au niveau de la zone de réalisation de la zone conductrice de grille du transistor mémoire, supérieure ou égale à l'épaisseur cumulée de la grille du transistor de sélection et de l'empilement.

10. Procédé selon l'une des revendications 6 à 9 **caractérisé en ce que** les vitesses de gravure de la résine et du matériau sacrificiel sont sensiblement identiques lors du transfert (204) de la forme dudit motif de résine dans la couche de matériau sacrificiel par gravure du matériau sacrificiel et de la résine.

## Patentansprüche

1. Elektronische Speicherzelle (100, 400), umfassend:
- ein Substrat (101), auf dem ein aktiver Kanalbereich (102) gebildet ist, der in einem Halbleitermaterial realisiert ist und einen Kanal (103) umfasst, der zwischen einer Drainerweiterungsregion (104) und einer Quellerweiterungsregion (105) angeordnet ist;
- eine erste Gitterstruktur, bezeichnet als Auswahlgitter (106), die einen ersten Teil (103₁) des genannten Kanals (103) überragt;
- einen lateralen Abstandshalter (107), der gegen wenigstens eine laterale Flanke (108) des genannten Gitters des Auswahltransistors (106) angeordnet ist, wobei der genannte laterale Abstandshalter (107) eine zweite Gitterstruktur, bezeichnet als Gitter des Speichertransistors (109), umfasst, die einen zweiten Teil (103₂) des genannten Kanals (103) überragt, wobei das genannte Gitter des Speichertransistors (109) umfasst:
∘ eine Schichtenstapelung (110), bei der eine der genannten Schichten (111) geeignet ist, um elektrische Ladungen zu stapeln, wobei die genannte Stapelung (110) einen ersten Stapelungsbereich (110₁) in Kontakt mit dem genannten zweiten Teil des genannten Kanals (103 ₂) und einen zweiten Stapelungsbereich (110₂) in Kontakt mit der genannten lateralen Flanke (108) des genannten Gitters des Auswahltransistors (106) einschließt;
∘ eine erste laterale Seite (113) in Kontakt mit dem genannten zweiten Stapelungsbereich (1102) derart, dass letzterer die genannte laterale Flanke (108) des Gitters des Auswahltransistors (106) und die genannte erste laterale Seite (113) trennt;
▪ eine deutlich ebene und zur Ebene des Substrats (101) parallele Unterseite (114), wobei die genannte Unterseite (114) mit dem genannten ersten Stapelungsbereich (110₁) derart in Kontakt ist, dass der genannte erste Stapelungsbereich (110₁) den genannten zweiten Teil (103₂) des genannten Kanals (103) und der genannten unteren Seite (114) trennt;
▪ eine zur Ebene des Substrats (101) deutlich ebene und parallele obere Seite (115);
▪ eine zweite laterale Seite (116), wobei die erste und zweite laterale Seite (113, 116) die genannte untere Seite (114) mit der genannten oberen Seite (115) verbindet
wobei die genannte elektronische Speicherzelle **dadurch gekennzeichnet ist, dass** die genannte zweite laterale Seite (116) in einem Winkel α geneigt ist, der strikt zwischen 0 und 90° im Verhältnis zur Ebene des Substrats (101) derart inbegriffen ist, dass die Länge (L) der genannten oberen Seite (115) strikt größer ist als die Länge (L_{MG}) der genannten unteren Seite (114), wobei die genannten Längen (L, L_{MG}) als die Entfernung zwischen der genannten ersten (113) und zweiten (116) lateralen Seiten gemäß der Länge des genannten Kanals (103) gemessen sind.

2. Speicherzelle gemäß Anspruch 1, **dadurch gekennzeichnet, dass** der Winkel α größer als oder gleich 45° ist.

3. Speicherzelle gemäß dem voranstehenden Anspruch, **dadurch gekennzeichnet, dass** der Winkel α zwischen 45° und 70° inbegriffen ist.

4. Speicherzelle gemäß einem der voranstehenden Ansprüche, **dadurch gekennzeichnet, dass** die zum Speichern der elektrischen Ladungen der genannten Stapelung geeignete Schicht zwischen zwei Schichten als dielektrischem Material der genannten Stapelung angeordnet ist.

5. Speicherzelle gemäß irgendeinem der voranstehenden Ansprüche, **dadurch gekennzeichnet, dass** die genannte, zum Speichern der elektrischen Ladungen geeignete Schicht eine Nitridschicht oder eine Schicht ist, die Nanokristalle, wie z. B. Silizium-Nanokristalle umfasst.

6. Herstellungsverfahren (200) einer Speicherzelle gemäß einem der voranstehenden Ansprüche, **dadurch gekennzeichnet, dass** die Realisierung des Gitterleiterbereichs des Speichertransistors, der die genannte zweite laterale geneigte Seite des genannten Winkels a, der im Verhältnis zur Ebene des Substrats strikt zwischen 0 und 90° inbegriffen ist, aufweist, die folgenden Schritte umfasst:
- Aufbringen einer Schicht aus Opfermaterial (201);
- Realisieren (203) eines Harzmusters, das wenigstens eine geneigte Flanke umfasst, die einen im Verhältnis zur Ebene des Substrats stumpfen Neigungswinkel β aufweist auf der genannten Schicht aus Opfermaterial;
- Übertragung (204) der Form des genannten Harzmusters in die Schicht aus Opfermaterial per Ätzen des Opfermaterials und des Harzes derart, dass ein Muster aus Opfermaterial erhalten wird, das wenigstens eine geneigte Flanke aufweist, das einen im Verhältnis zur Ebene des Substrats stumpfen Neigungswinkel β' gleich (180° - α) aufweist, wobei α der gesuchte spitze Neigungswinkel der zweiten lateralen Seite ist;
- konformes Aufbringen (205) eines Leitermaterials, das die Räume ausfüllt, die auf jeder Seite des Musters aus Opfermaterial derart angeordnet sind, dass das Leitermaterial die Form der geneigten Flanke annimmt;
- Abnehmen (206, 207, 208) eines Teils des Leitermaterials und des gesamten Opfermaterials derart, dass der Gitterleiterbereich des Speichertransistors, der in dem genannten Leitermaterial realisiert ist und eine laterale Seite aufweist, die um einen Winkel α geneigt ist, der im Verhältnis zur Ebene des Substrats strikt zwischen 0 und 90° geneigt ist, beibehalten wird, wobei die genannte laterale Seite vor dem Abnehmen des Opfermaterials der Kontaktseite mit der geneigten Flanke des Musters aus Opfermaterial entspricht.

7. Verfahren gemäß dem voranstehenden Anspruch, **dadurch gekennzeichnet, dass** die Realisierung (203) eines Harzmusters, das wenigstens eine geneigte Flanke umfasst, die einen stumpfen Neigungswinkel β aufweist, auf der genannten Schicht aus Opfermaterial durch einen Lithographie- und Kriechschritt einer Harzschicht erhalten ist.

8. Verfahren gemäß einem der Ansprüche 6 oder 7, **dadurch gekennzeichnet, dass** das Verfahren die folgenden Schritte vor dem Aufbringen einer Schicht aus Opfermaterial umfasst:
- Bildung (200) des Auswahltransistors;
- Aufbringen (200) der Schichtenstapelung, von der eine der genannten Schichten geeignet ist, um elektrische Ladungen zu speichern, wobei das Aufbringen der Schicht aus Opfermaterial oberhalb der Schichten der Stapelung realisiert ist.

9. Verfahren gemäß dem voranstehenden Anspruch, **dadurch gekennzeichnet, dass** die Dicke der Schicht aus Opfermaterial an dem Realisierungsbereich der Gitterleiterschicht des Speichertransistors größer als oder gleich der kumulierten Dicke des Gitters des Auswahltransistors und der Stapelung ist.

10. Verfahren gemäß einem der Ansprüche 6 bis 9, **dadurch gekennzeichnet, dass** die Ätzgeschwindigkeiten des Harzes und des Opfermaterials bei der Übertragung (204) der Form des genannten Harzmusters in die Schicht aus Opfermaterial per Ätzen des Opfermaterials und des Harzes deutlich identisch sind.

## Claims

1. An electronic memory cell (100, 400) including:
- a substrate (101) on which a channel active zone (102) made of a semiconductor material and including a channel (103) disposed between a drain extension region (104) and a source extension region (105) is formed;
- a first gate structure, called a selection gate (106), on top of a first part (103₁) of said channel (103);
- a side spacer (107) disposed against at least one side flank (108) of said selection transistor gate (106), said side spacer (107) comprising a second gate structure, called a memory transistor gate (109), on top of a second part (103₂) of said channel (103), said memory transistor gate (109) including:
∘ a stack (110) of layers of which one of said layers (111) is adapted to store electric charges, said stack (110) including a first stack zone (110₁) in contact with said second part of said channel (103₂) and a second stack zone (110₂) in contact with said side flank (108) of said selection transistor gate (106);
∘ a gate conductive zone (112) of the memory transistor including
▪ a first side face (113) in contact with said second stack zone (110₂) such that the latter separates said side flank (108) from the selection transistor gate (106) and said first side face (113);
▪ a substantially planar lower face (114) parallel to the plane of the substrate (101), said lower face (114) being in contact with said first stack zone (110₁) such that said first stack zone (110₁) separates said second part (103₂) from said channel (103) and said lower face (114);
▪ a substantially planar upper face (115) parallel to the plane of the substrate (101);
▪ a second side face (116), said first and second side faces (113, 116) connecting said lower face (114) to said upper face (115),
said electronic memory cell being **characterized in that** said second side face (116) is tilted by an angle α strictly between 0 and 90° with respect to the plane of the substrate (101) such that the length (L) of said upper face (115) is strictly higher than the length (L_{MG}) of said lower face (114), said lengths (L, L_{MG}) being measured as the distance between said first (113) and second (116) side faces along the length of said channel (103).

2. The memory cell according to claim 1, **characterised in that** the angle α is higher than or equal to 45°.

3. The memory cell according to the preceding claim, **characterised in that** the angle α is between 45° and 70°.

4. The memory cell according to one of the preceding claims, **characterised in that** the layer adapted to store electric charges of said stack is disposed between two layers of dielectric material of said stack.

5. The memory cell according to one of the preceding claims, **characterised in that** said layer adapted to store electric charges is a layer of nitride or a layer including nanocrystals such as silicon nanocrystals.

6. A method (200) for manufacturing a memory cell according to one of the preceding claims, **characterised in that** making the gate conductive zone of the memory transistor having said second side face tilted by said angle α strictly between 0 and 90° with respect to the plane of the substrate includes the following steps of:
- depositing a layer of sacrificial material (201);
- making (203) on said layer of sacrificial material a resin pattern including at least one tilted flank having a tilting obtuse angle β with respect to the plane of the substrate;
- transferring (204) the form of said resin pattern into the layer of sacrificial material by etching the sacrificial material and the resin so as to obtain a pattern of sacrificial material including at least one tilted flank having a tilting obtuse angle β' with respect to the plane of the substrate substantially equal to (180°-α) where α is the intended tilting acute angle of the second side face;
- conformally depositing (205) a conductive material filling the spaces located on either side of the pattern of sacrificial material such that the conductive material fits the shape of the tilted flank;
- removing (206, 207, 208) part of the conductive material and the entire sacrificial material so as to keep the gate conductive zone of the memory transistor made of said conductive material and having a side face tilted by an angle α strictly between 0 and 90° with respect to the plane of the substrate, said side face corresponding, before removing the sacrificial material, to the contact face with the tilted flank of the pattern of sacrificial material.

7. The method according to the preceding claim, **characterised in that** making (203) on said layer of sacrificial material a resin pattern including at least one tilted flank having a tilting obtuse angle β is achieved by a lithography and flow step of a resin layer.

8. The method according to one of claims 6 or 7, **characterised in that** the method includes the following steps prior to depositing a layer of sacrificial material:
- forming (200) the selection transistor;
- depositing (200) the stack of layers of which one of said layers is adapted to store electric charges, depositing the layer of sacrificial material being made above the layers of the stack.

9. The method according to the preceding claim, **characterised in that** the thickness of the layer of sacrificial material is, at the zone for making the gate conductive zone of the memory transistor, higher than or equal to the cumulative thickness of the selection transistor gate and the stack.

10. The method according to one of claims 6 to 9, **characterised in that** the etching rates of the resin and the sacrificial material are substantially identical upon transferring (204) the shape of said resin pattern in the layer of sacrificial material by etching the sacrificial material and the resin.
